Europäisches Patentamt

European Patent Office

Office européen des brevets

(19)

(11) Veröffentlichungsnummer: **0 352 734 B1**

(12) **EUROPÄISCHE PATENTSCHRIFT**

(45) Veröffentlichungstag der Patentschrift: **29.09.93**

(51) Int. Cl.5: **G01R 19/165**

(21) Anmeldenummer: **89113693.9**

(22) Anmeldetag: **25.07.89**

(54) **Schaltungsanordnung zur Überwachung einer auf Null-Potential bezogenen Spannungsquelle gegenüber zwei Vergleichsspannungen.**

(30) Priorität: **26.07.88 DE 3825383**

(43) Veröffentlichungstag der Anmeldung:
**31.01.90 Patentblatt 90/05**

(45) Bekanntmachung des Hinweises auf die
Patenterteilung:
**29.09.93 Patentblatt 93/39**

(84) Benannte Vertragsstaaten:
**DE FR GB IT NL SE**

(56) Entgegenhaltungen:
**DE-A- 2 936 675**

**ELEKTOR, Band 3, Nr. 7/8, 1977, Seite 47,
Zusammenfassung Nr. 56, Canterbury, GB; R.
SLOAN: "Tri-state voltage comparator"**

**PATENT ABSTRACTS OF JAPAN, Band 5, Nr.
44 (E-50)[716], 24. März 1981, Seite 126 E 50;
& JP-A-56 749**

**PATENT ABSTRACTS OF JAPAN, Band 4, Nr.
32 (E-2)[514], 19. März 1980, Seite 24 E 2;&
JP-A-55 4117**

(73) Patentinhaber: **SIEMENS AKTIENGESELL-
SCHAFT**
**Wittelsbacherplatz 2**
**D-80312 München(DE)**

(72) Erfinder: **Bichler, Helmut**
**Bahnhofstrasse 103**
**D-8032 Gräfelfing(DE)**

EP 0 352 734 B1

## Beschreibung

Die Erfindung betrifft eine Schaltungsanordnung zur Überwachung einer auf Null-Potential bezogenen Spannungsquelle gegenüber zwei Vergleichsspannungen gemäß dem Oberbegriff des Patentanspruchs 1.

Für eine Vielzahl von Anwendungen benötigt man Schaltungsanordnungen, mit denen es sich feststellen läßt, ob eine gegebene Eingangsspannung zwischen zwei Vergleichsspannungen oder außerhalb leigt. Aus Tietze-Schenk, Halbleiterschaltungstechnik, 5. Auflage, S. 413 ist beispielsweise bekannt, eine derartige Schaltungsanordnung, auch Fensterkomparator genannt, durch zwei Komparatoren, deren Ausgänge jeweils mit einem Eingang eines UND-Gatters verknüpft sind, zu verwirklichen. Dabei wird die zu überwachende Eingangsspannung an den aus dem invertierenden Eingang des einen und aus dem nichtinvertierenden Eingang des anderen Komparators gebildeten Knotenpunkt geführt. Die jeweils anderen Eingänge der Komparatoren sind jeweils mit einer Referenzspannungsquelle verbunden. Das Einstellen der Vergleichsspannungswerte erfolgt über das Verändern der Spannungswerte der Referenzspannungsquellen.

Eine alternative Realisierungsmöglichkeit ist unter anderem bei Linear Technology, Linear Databook 1986, S.5-42 beschrieben. Die Ausgänge der beiden Komparatoren sind wiederum mit den Eingängen eines UND-Gatters verknüpft. Der aus dem invertierenden Eingang des einen und dem nicht invertierenden Eingang des anderen Komparators hervorgehende Knotenpunkt ist jedoch mit einer Referenzspannungsquelle verbunden. Die zu überwachende Eingangsspannung wird auf einen Spannungsteiler mit zwei Abgriffen geführt, wobei die Abgriffe jeweils mit einem der anderen Eingänge der Komparatoren verschaltet sind. Die Einstellung der Vergleichsspannungswerte geschieht in diesem Fall über die Dimensionierung der Spannungsteilerverhältnisse.

Bei der Integration der von außen justierbaren Fensterkomparatoren, insbesondere wenn mehrere Fensterkomparatoren in einem Gehäuse Platz finden sollen, ist man bestrebt, die Zahl der herausgeführten Schaltungsanschlüsse zu minimieren und den externen Schaltungsaufwand möglichst gering zu halten. Bei den bekannten Anordnungen sind dazu günstigstenfalls zwei herausgeführte Anschlüsse und ein aus drei Widerständen bestehender Spannungsteiler notwendig.

Die Aufgabe der Erfindung ist es, eine Schaltungsanordnung zur Überwachung einer Eingangsspannung gegenüber zwei Vergleichsspannungen anzugeben, welche einen geringeren Beschaltungsaufwand benötigt.

Die Aufgabe wird bei einer gattungsgemäßen Schaltungsanordnung durch die kennzeichnenden Merkmale des Patentanspruchs 1 gelöst.

Eine Ausgestaltung der Erfindung ist Gegenstand eines Unteranspruches.

Die Erfindung bringt den Vorteil mit sich, daß bei Einstellung der beiden Vergleichsspannungswerte nur ein herausgeführter Anschluß und zwei Widerstände erforderlich sind.

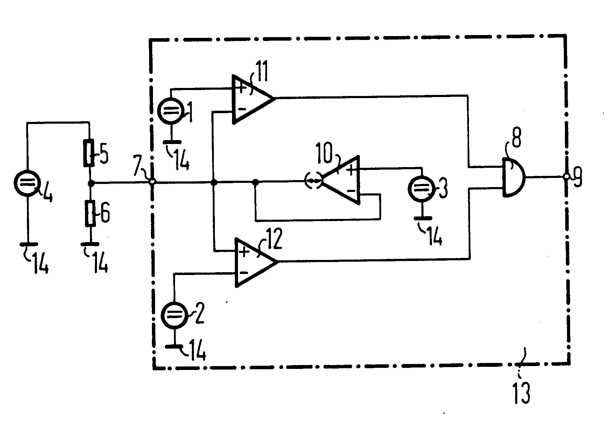

Ein Ausführungsbeispiel der Erfindung ist in der einzigen Figur der Zeichnung dargestellt und wird im folgenden näher beschrieben.

Die Ausgänge eines ersten Komparators 11 und eines zweiten Komparators 12 sind jeweils mit einem Eingang eines UND-Gatters 8, dessen Ausgang den Ausgang 9 einer Fensterkomparatorschaltung 13 darstellt, verknüpft. Der nichtinvertierende Eingang des ersten Komparators 11 ist mit einer auf Null-Potential bezogenen, ersten Referenzspannungsquelle 1 und der invertierende Eingang des zweiten Komparators 12 ist mit einer auf Null-Potential bezogenen zweiten Referenzspannungsquelle 2 verbunden. Bei dem gezeigten Ausführungsbeispiel wird das Null-Potential durch Masse 14 gebildet. Der invertierende Eingang des ersten Komparators 11 und der nichtinvertierende Eingang des zweiten Komparators 12 bilden zusammen einen Knotenpunkt, der als Eingang 7 der Fensterkomparatorschaltung 13 vorgesehen ist. An diesen Knotenpunkt ist zudem der invertierende Eingang und der Ausgang einer als spannungsgesteuerte Stromquelle bzw. spannungsgesteuerte Stromsenke wirkende Verstärkerschaltung 10, der nichtinvertierende Eingang an einer auf Masse 14 bezogenen dritten Referenzspannungsquelle 3 angeschlossen. Der Eingang 7 der Fensterkomparatorschaltung 13 ist mit dem Abgriff eines einerseits auf Masse 14 liegenden, andererseits mit einem aus einer auf Masse 14 bezogenen, zu überwachenden Spannungsquelle 4 gespeisten und aus zwei Widerständen 5, 6 bestehenden Spannungsteiler verbunden. Der Widerstand 6 liegt dabei mit einem Anschluß auf Masse 14. In Ausgestaltung der Erfindung weisen beide Komparatoren 11, 12 ein Hystereseverhalten auf. Dies bringt den Vorteil mit sich, daß Schwingeneigungen am Umschaltpunkt unterdrückt werden.

Nachdem zuvor der prinzipielle Aufbau der Schaltungsanordnung beschrieben worden ist, wird nun auf deren Funktionsweise näher eingegangen.

Liegt am Eingang 7 der Fensterkomparatorschaltung 13 eine Spannung an, die gleich der Spannung der dritten Referenzspannungsquelle 3 ist, so liefert die Verstärkerschaltung 10 keinen Strom. Steigt die Spannung am Eingang 7 an, zieht die Verstärkerschaltung 10 Strom ab, wo hingegen beim Absinken der Spannung die Verstärkerschaltung 10 Strom liefert. Der von der Verstärkerschaltung 10 hervorgerufene und von der Spannung am Eingang 7 abhängige Strom bewirkt einen Spannungsabfall, der sich dem durch die zu überwachende Spannungsquelle 4 bewirkten Spannungsabfall überlagert. Bis zu einem gewissen Grad kann die von der zu überwachenden Spannungsquelle 4 ausgehende Spannungsverschiebung durch die Verstärkerschaltung 10 innerhalb des durch die beiden Komparatoren 11, 12 und die zugehörigen Referenzspannungsquellen 1, 2 vorgegebenen Bereiches ausgeglichen werden. Ist jedoch die Spannungsverschiebung zu groß, so wird einer der beiden Komparatoren 11, 12 aktiviert und ein entsprechendes Signal erscheint am Ausgang 9 der Fensterkomparatorschaltung 13.

Formal läßt sich die Funktionsweise der gezeigten Schaltungsanordnung folgendermaßen beschreiben:
Durch die erste und zweite Referenzspannungsquelle 1, 2 sind die Vergleichsspannungswerte der Fensterkomparatorschaltung 13, im folgenden interne Vergleichswerte $U_1$, $U_2$ genannt, festgelegt. Die von der dritten Referenzspannungsquelle 3 abgegebene, auf Masse bezogene Spannung $U_R$ liegt zwischen den beiden, ebenfalls auf Masse bezogenen, internen Vergleichswerten $U_1$, $U_2$ und gehorcht für das dargestellte Ausführungsbeispiel der Bedingung $U_1 > U_R > U_2$. Die Abhängigkeit des von der Verstärkerschaltung 10 gelieferten Ausgangsstromes I von der Differenz aus der Spannungs $U_R$ und der Spannung $U_E$ am Eingang der Fensterkomparatorschaltung 10 wird formal durch einen Übertragungsfaktor k ausgedrückt. Für die beiden internen Vergleichsspannungswerte $U_1$, $U_2$ ergeben sich somit die Ausgangsströme $I_1$, $I_2$ zu

$$I_1 = k(U_R - U_1) \quad (1)$$

$$I_2 = k(U_R - U_2) \quad (2)$$

Durch die äußere Beschaltung mit den Widerständen 5, 6 und in Zusammenhang mit der Verstärkerschaltung 10 werden die internen Vergleichswerte $U_1$, $U_2$ zu den externen Vergleichswerten $U_o$, $U_u$ transformiert. Die Umrechnung erfolgt gemäß Gleichung

$$U_E = R_6(I + (U - U_E)/R_5) \quad (3)$$

und ergibt die Beziehungen

$$R_1 = (U_1 U_u - U_2 U_o)/(U_1 I_1 - U_1 I_2) \quad (4),$$

$$R_2 = (U_1 U_u - U_2 U_o)/(U_u I_1 - U_2 I_1 - U_o I_2 + U_1 I_2) \quad (5)$$

in Abhängigkeit von der zu überwachenden Spannung U.

Abschließend sei bemerkt, daß, wie auch bei bereits bekannten Fensterkomparatoranordnungen, die Ausgänge der Komparatoren sowohl in positiver als auch in negativer Logik ausgeführt werden und darüber hinaus auch getrennt herausgeführt werden können.

**Patentansprüche**

1. Schaltungsanordnung zur Überwachung einer auf Null-Potential (14) bezogenen Spannungsquelle (4) gegenüber zwei Vergleichsspannungen mittels einer Fensterkomparatorschaltung (13), bestehend aus einem ersten Komparator (11), dessen nichtinvertierender Eingang an einer auf Null-Potential (14) bezogenen, ersten Referenzspannungsquelle (1) liegt, aus einem zweiten Komparator (12), dessen invertierender Eingang mit einer auf Null-Potential (14) bezogenen zweiten Referenzspannungsquelle (2) und dessen nichtinvertierender Eingang mit dem invertierenden Eingang des ersten Komparators (11) den Eingang (7) der Fensterkomparatorschaltung (13) bildend verschaltet ist, und aus einem mit seinem Ausgang den Ausgang (9) der Fensterkomparatorschaltung (13) bildenden UND-Gatter (8), dessen erster Eingang mit dem Ausgang des ersten Spannungskomparators (11) und dessen zweiter Eingang mit dem Ausgang des zweiten Spannungskomparators (12) verbunden ist, **dadurch gekennzeichnet**, daß eine als spannungsgesteuerte Stromquelle/Stromsenke wirkende Verstärkerschaltung (10), deren nichtinvertierender Eingang an eine auf Null-Potential (14) bezogene, dritte Referenzspannungsquelle (3) angeschlossen ist, über ihren Ausgang und ihren invertierenden Eingang mit dem Eingang (7) der Fensterkomparatorschaltung (13) verbunden ist, daß ein aus zwei Widerständen (5, 6) bestehender Spannungsteiler, an dessen Abgriff der Eingang (7) des Fensterkomparators (13) liegt, der zu überwachenden Spannungsquelle (4) parallelgeschaltet ist und wobei die erste und die zweite Referenzspannungsquelle (1, 2) so dimensioniert sind, daß die Spannung der zu überwachenden Spannungsquelle (4) zwischen den Spannungen der ersten und der zweiten Referenzspannungsquelle (1, 2) liegt.

2. Schaltungsanordnung nach Anspruch 1, **dadurch gekennzeichnet**, daß die beiden Komparatoren (11, 12) eine Schalthysterese aufweisen.

## Claims

1. Circuit arrangement for monitoring a voltage source (4) referred to zero potential (14) compared with two reference voltages by means of a window comparator circuit (13) consisting of a first comparator (11), the non-inverting input of which is connected to a first reference voltage source (1) referred to zero potential (14), of a second comparator (12), the inverting input of which is connected to a second reference voltage source (2) referred to zero potential (14) and the non-inverting input of which is connected to the inverting input of the first comparator (11) forming the input (7) of the window comparator circuit (13), and of an AND gate (8) forming with its output the output (9) of the window comparator circuit (13), the first input of which is connected to the output of the first voltage comparator (11) and the second input of which is connected to the output of the second voltage comparator (12), characterised in that an amplifier circuit (10) acting as voltage-controlled current source/current sink, the non-inverting input of which is connected to a third reference voltage source (3) referred to zero potential (14), is connected via its output and its inverting input to the input (7) of the window comparator circuit (13), in that a voltage divider consisting of two resistors (5, 6), at the tap of which the input (7) of the window comparator (13) is connected, is connected in parallel with the voltage source (4) to be monitored, the first and the second reference voltage source (1, 2) being dimensioned in such a manner that the voltage of the voltage source (4) to be monitored is between the voltages of the first and the second reference voltage source (1, 2).

2. Circuit arrangement according to Claim 1, characterised in that the two comparators (11, 12) exhibit a switching hysteresis.

## Revendications

1. Montage pour contrôler une source de tension (4), rapportée au potentiel nul (14), par rapport à deux tensions de comparaison au moyen d'un circuit comparateur à fenêtre (13), constitué par un premier comparateur (11), dont l'entrée non inverseuse est raccordée à une première source de tension de référence (1), rapportée au potentiel nul (14), par un second comparateur (12), dont l'entrée inverseuse est raccordée à une seconde source de tension de référence (2), rapportée au potentiel nul (14) et dont l'entrée non inverseuse est raccordée à l'entrée inverseuse du premier comparateur (11), en formant l'entrée (7) du circuit comparateur à fenêtre (13), et par une porte ET (8), qui forme, par sa sortie, la sortie (9) du circuit comparateur à fenêtre (13) et dont la première entrée est raccordée à la sortie du premier comparateur de tension (11) et dont la seconde entrée est raccordée à la sortie du second comparateur de tension (12), caractérisé en ce qu'un circuit amplificateur (10), qui agit en tant que source de courant/récepteur de courant, commandé par la tension, et dont l'entrée non inverseuse est raccordée à une troisième source de tension de référence (3), rapportée au potentiel nul (14), est connectée par l'intermédiaire de sa sortie et de son entrée inverseuse à l'entrée (7) du circuit comparateur à fenêtre (13), qu'un diviseur de tension, constitué par deux résistances (5, 6) et à la prise duquel est connectée l'entrée (7) du comparateur à fenêtre (13), est branché en parallèle avec la source de tension (4) à contrôler, les première et seconde sources de tension de référence (1,2) étant dimensionnées de telle sorte que la tension de la source de tension à contrôler (4) se situe entre les tensions des première et seconde sources de tension de référence (1,2).

2. Montage suivant la revendication 1, caractérisé par le fait que les deux comparateurs (11, 12) possèdent une hystérésis de commutation.